Europäisches Patentamt

European Patent Office

Office européen des brevets

(11) Publication number: **0 153 526**
**A2**

# EUROPEAN PATENT APPLICATION

(21) Application number: **84304414.0**

(22) Date of filing: **28.06.84**

(51) Int. Cl.⁴: **C 23 C 14/34**

(30) Priority: **17.02.84 US 581103**

(43) Date of publication of application:
**04.09.85 Bulletin 85/36**

(84) Designated Contracting States:
**AT BE CH DE FR GB IT LI LU NL SE**

(71) Applicant: **STAUFFER CHEMICAL COMPANY**

**Westport Connecticut 06881(US)**

(72) Inventor: **Schachter, Rozalie**
**75-14, 173rd Street**
**Flushing, N.Y. 11366(US)**

(72) Inventor: **Viscogliosi, Marcello**
**176 North Washington Street**
**North Tarrytown, N.Y. 10591(US)**

(74) Representative: **Smith, Sydney et al,**
**Elkington and Fife High Holborn House 52/54 High**
**Holborn**
**London WC1V 6SH(GB)**

(54) Vacuum deposition processes employing a continuous pnictide delivery system, particularly sputtering.

(57) A pnictide film deposition apparatus characterised in that it comprises:

  (A) a reservoir for containing heated pnictide;
  (B) means for passing an inert gas therethrough;
  (C) a vacuum film deposition chamber; and
  (D) means for supplying the said inert gas carrying the said pnictide as a vapour species after passing through the said pnictide to the said deposition chamber is disclosed.

A process for the vacuum deposition of pnictide film characterised in that it comprises passing an inert gas through heated pnictide and supplying the product gas to a vacuum chamber is also disclosed.

Films of pnictide, polypnictide and other pnictide compounds may be deposited for semiconductor, thin film transistors and other applications including insulation and passivation, particularly on III-V semiconductors. The local order of the deposited films may be controlled by varying the amount of energy delivered to the surface of the substrate, which is a function of its temperature, the RF power used and the amount of excess Pnictide$_4$ supplied.

Referring to the accompanying illustrative drawing, the present apparatus may comprise reservoir 70, inert gas supply 48, chamber 44 and means for pnictide vapour supply to chamber 76.

The present invention represents an advance over the prior art.

./...

FIG. 2

# VACUUM DEPOSITION PROCESSES EMPLOYING A CONTINUOUS PNICTIDE DELIVERY SYSTEM, PARTICULARLY SPUTTERING

This invention relates to vacuum deposition processes employing a continuous pnictide delivery system, particularly sputtering; it also relates to sputtered semiconducting films of pnictide material, particularly $KP_{15}$, $KP_x$ wherein x ranges from 15 to infinity, phosphorus, InP, GaP and GaAs; to the production of electronic semiconductor devices, electro-optical devices, thin films, optical films and coatings; to III-V semiconductor devices and to the passivation and insulation thereof.

For further information, reference may be made to, for example, GB-A-2,113,663 and to the related applications filed herewith, in particular those based on USSN 581,139, USSN 509,157, USSN 509,175, USSN 581,115, USSN 509,158, USSN 581,105, USSN 581,104, USSN 581,102 and USSN 581,101.

In the above-identified related application based on USSN 509,175 there is disclosed formation of polyphosphide films by sputtering.

Certain of the above-identified related applications disclose the insulation and passivation of III-V semiconductors with pnictide films, particularly phosphorus.

One of the above-identified related applications discloses a continuous pnictide source and delivery system for chemical vapour deposition.

It is therefore an object of the present invention to provide a $Pnictide_4$, particularly a $P_4$, delivery system for vacuum film deposition.

Another object of the present invention is to provide such a continuous delivery system.

A further object of the present invention is to provide such a source utilizing an inert carrier gas.

A still further object of the present is to facilitate the deposition of films of pnictides, poly-pnictides and other pnictide compounds, particularly when the pnictide is phosphorus, by sputtering.

Yet another object of the present invention is to control the local order of a sputtered pnictide film.

A further object of the present invention is to deposit films of III-V materials, particularly InP, GaP and GaAs.

The present invention provides a pnictide film deposition apparatus characterised in that it comprises:

   (A) a reservoir for containing heated pnictide;

   (B) means for passing an inert gas therethrough;

   (C) a vacuum film deposition chamber; and

   (D) means for supplying the said inert gas carrying the said pnictide as a vapour species after passing through the said pnictide to the said deposition chamber.

In a preferred embodiment, the deposition chamber comprises sputtering apparatus, in particular RF sputtering apparatus.

The present invention also provides a process for the vacuum deposition of a pnictide film characterised in that it comprises passing an inert gas through heated pnictide and supplying the product gas to a vacuum chamber.

Vacuum chamber pressure is preferably maintained at above $10^{-4}$ Torr ($1.33 \times 10^{-2}$ Pa), more preferably above $10^{-3}$ Torr ($1.33 \times 10^{-1}$ Pa). The present process generally comprises sputtering in the vacuum chamber in the presence of a Pnictide$_4$ species introduced in the carrier gas so as to deposit a pnictide film, which may be elemental or compound, on a substrate. If, a compound, it is preferably a III-V compound, such as InP or GaAs. The pnictide may be P, As or Sb.

It may be desirable to control the local order of the pnictide film by controlling the temperature of the substrate and/or the sputtering power and/or the rate of supply of the pnictide species. The film may be a polypnosphide or $KP_x$ wherein x is at least 15. The pnictide may be a compound semiconductor.

It has now been found that polypnictide films may be grown in a vacuum system only in the presence of excess pnictide. It has now been found that a continuous pnictide source may be employed to supply $Pnictide_4$ species carried in an inert gas into the sputterer to supply the excess pnictide species.

Using a target of condensed phase $KP_{15}$ pressed into a pellet and a phosphorus bubbler as disclosed in the above-identified related application based on USSN 581,102, it has been found that not only can very good films of $KP_{15}$ and phosphorus be formed on various substrates including III-V materials, but that the local order of these films may be controlled by controlling the temperature of the substrate, the RF power applied and the rate of supply of excess phosphorus.

Also, an indium phosphide film has been successfully grown on glass substrates and there is no reason why indium phosphide should not be grown epitaxially on indium phosphide crystals. Moreover, it should be possible to deposit and epitaxially grow other III-V materials, particularly GaAs, using this system.

For a fuller understanding of the nature and objects of the present invention reference may be made to the accompanying illustrative drawings wherein:

Figure 1 is a diagram of an RF vacuum sputterer utilizing a pnictide bubbler according to the present invention;

Figure 2 is a diagram of the system illustrated in Figure 1 showing the details of the pnictide deilvery system;

Figure 3 is a plot of potassium deposition rate versus plasma power in the system illustrated in Figure 1;

Figure 4 is a plot of potassium deposition rate versus substrate temperature in the system illustrated in Figure 1; and

Figure 5 is a plot of phosphorus deposition rate versus excess $P_4$ multiplied by plasma power in the system illustrated in Figure 1.

The same reference numbers refer to the same elements throughout the several views of the drawings.

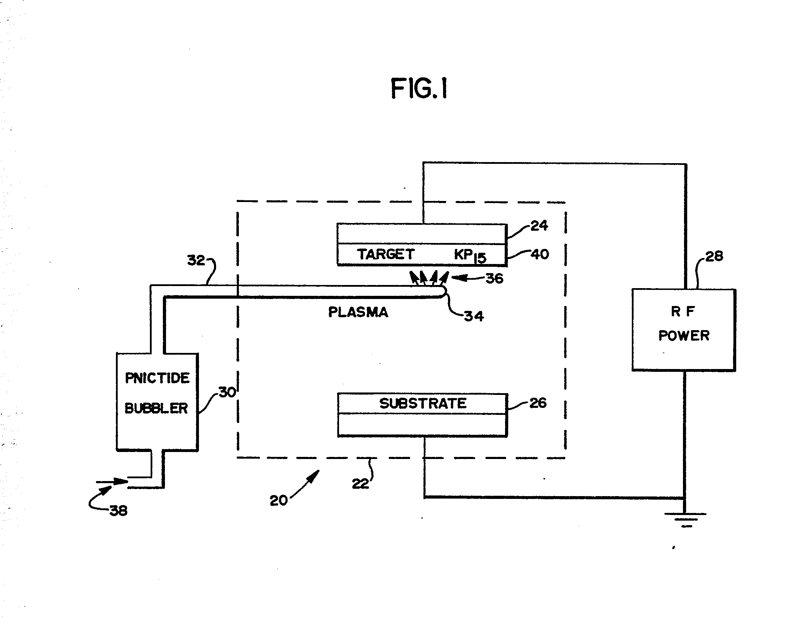

Referring to accompanying Figure 1, apparatus for sputtering utilizing a continuous pnictide delivery system, according to the present invention, is generally indicated at 20. It comprises a vacuum chamber 22 maintained at a vacuum above $10^{-4}$ Torr ($1.33 \times 10^{-2}$ Pa), preferably above $10^{-3}$ Torr ($1.33 \times 10^{-1}$ Pa), and particularly in a range of from 2 to $3 \times 10^{-2}$ Torr (from 2.66 to 3.99 Pa). Plate electrodes 24 and 26 within the vacuum chamber 22 are connected to an RF power generator 28 providing from 5 to 250 watts of power at 13.56 megahertz. The vacuum chamber 22 contains argon gas as the sputtering medium.

According to the present invention, a pnictide delivery system 30 constructed in the manner disclosed in the above-identified related application based on USSN 581,102 is utilized to supply a stream of Pnictide$_4$ vapour carried by argon gas in tube 32. This feeds a nozzle 34 having slots cut therein (not shown), to deliver the $P_4$ species as shown by the arrows 36. A source of argon gas is supplied to the pnictide bubbler as indicated by the arrow 38.

In certain experiments, the target 40 consisted of a pressed pellet of condensed phase $KP_{15}$, as disclosed in the above-identified related application based on USSN 509,175 produced in the manner disclosed in GB-A-2,113,663 mentioned above. The pnictide bubbler was filled with liquid white phosphorus and the $P_4$ phosphorus species carried by the argon gas supplied to the bubbler at 38, exits the nozzle 34 in the dark space of the glow discharge below the target.

The system is operated at a pressure of from 2 to 3 x $10^{-2}$ Torr (from 2.66 to 3.99 Pa). The peak voltage ranges from 50 to 2500 volts. The RF power range is from 5 to 250 watts. The bubbler temperature is maintained at from 50 to 150°C. The argon flow rate through the bubbler ranges from 5.5 to 65 standard cubic centimetres per minute. The pressure maintained in the pnictide source used ranges from atmospheric to subatmospheric. The flow rates of the $P_4$ species into the vacuum chamber 22 range from 2 x $10^{-6}$ to 6 x $10^{-3}$ grams per minute. The substrates 26 have been maintained at temperatures ranging from 23 to 400°C. Deposition rates have varied from 2 to 250Å (x$10^{-10}$m) per minute.

The $P_4$ system 36 is preferably directed upward into the dark space of the plasma where it is efficiently ionized and results in cracking of the $P_4$ species into various P species, which have a better sticking coefficient than $P_4$ and are required successfully to deposit polyphosphide films at the substrate 26.

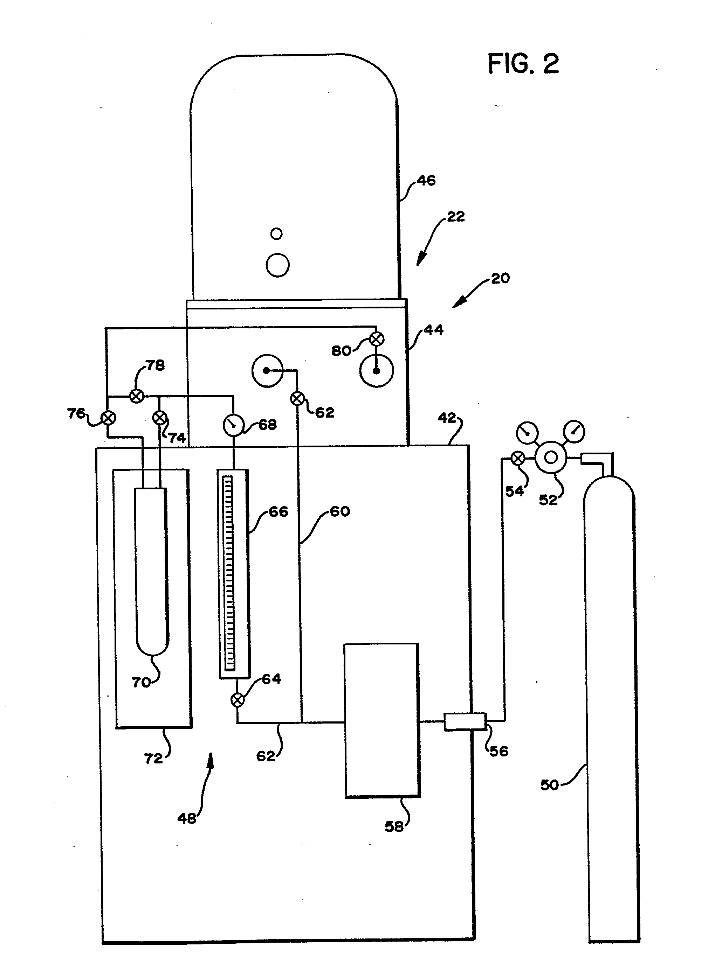

Referring now to accompanying Figure 2, the apparatus 20 according to the present invention may be, for example, a Materials Research Corporation Model 86-20 RF diode sputterer comprising vacuum chamber base 42, chamber 44 and RF oil cover 46. The argon bubbler apparatus generally indicated at 48 comprises an argon supply cylinder 50, regulator 52, shutoff valve 54, micron (μm) filter 56 and hydrox gas purifier 58 to supply the argon gas to the RF sputterer on line 60 and through valve 62 and to supply the bubbler itself on line 63 through needle valve 64.

The bubbler apparatus 48 comprises a flow meter 66, pressure gauge 68, the bubbler 70 surrounded by a heated bath 72, inlet valve 74, outlet valve 76 and purge valve 78. Inlet needle valve 80 is utilized to control the  ultimate flow rate into the vacuum chamber 22.

In the present studies, there have been made much improved, that is, more uniform, constant thickness, mirror surfaced $KP_{15}$ films. Also, there have been deposited phosphorus films on III-V materials, such as InP, GaP and GaAs, and on glass. Polycrystalline InP has been deposited on glass using a room temperature substrate. It is possible to grow crystalline InP epitaxially on InP substrates using a single crystal InP wafer target at higher substrate temperatures. These temperatures will range from 300 to 400°C. It is also possible to deposit GaAs and GaP in polycrystalline form on a room temperature substrate and to grow them epitaxially at these higher temperatures.

Ternary, quaternary and other semiconductors having two differing pnictides, such as GaAsP and InGaAsP, require two independent pnictide delivery systems according to the present invention (one for each pnictide element) to be grown epitaxially in the glow discharge. These semiconductors comprising two metals require composite targets of the two metal compound semconductors which are to be grown.

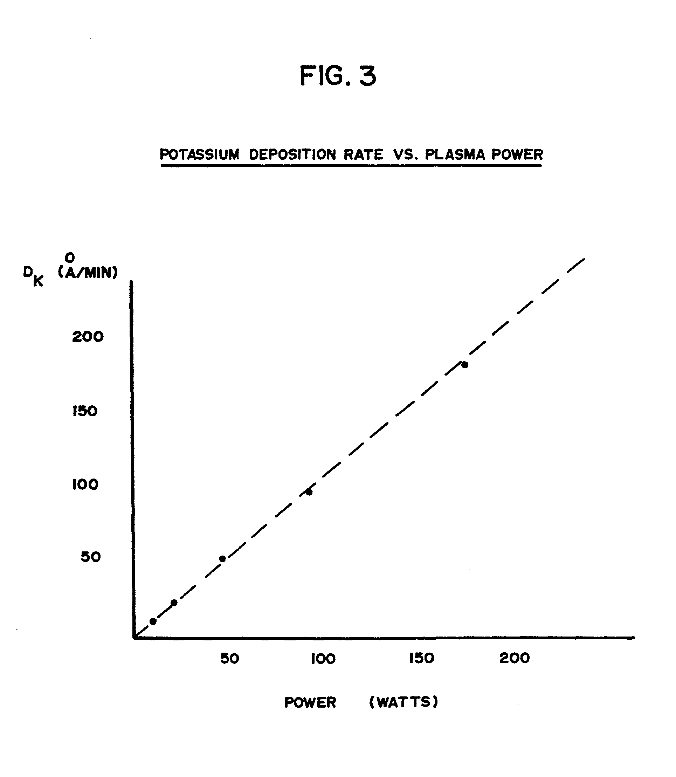

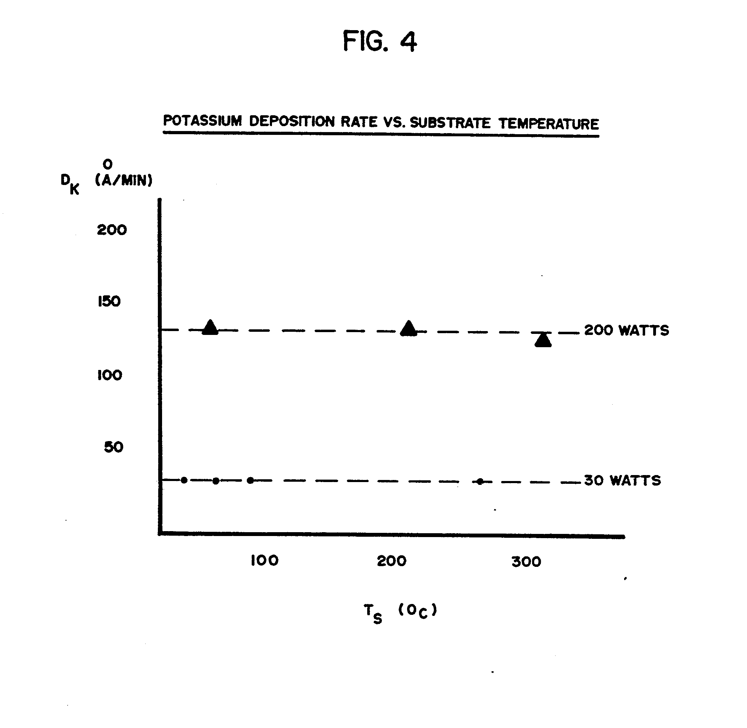

As illustrated in accompanying Figure 3, the potassium deposition rate $D_K$ versus plasma power found in the present apparatus is linear with regard to plasma power and, as illustrated in accompanying Figure 4, does not vary with substate temperature.

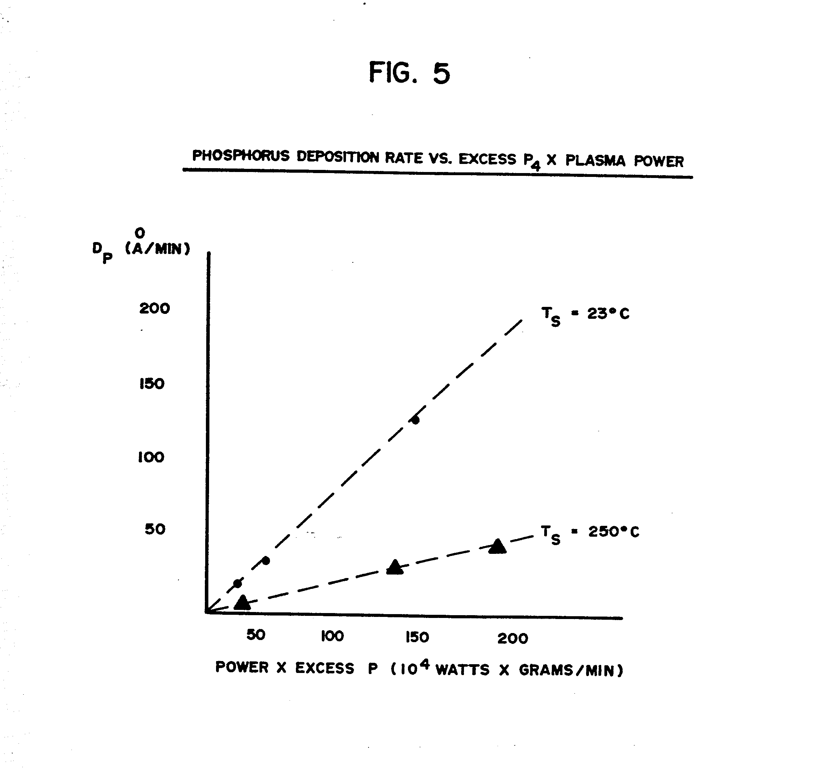

On the other hand, it has been found that the phosphorus deposition rate $D_p$ is a function of three variables, namely, the substrate temperature, the RF power and the rate of delivery of excess phosphorus to the system using the phosphorus bubbler. This may be seen from accompanying Figure 5. It may also be seen from accompanying Figure 5 that the deposition rate of phosphorus $D_p$ in angstroms ($10^{-10}$m) per minute is a linear function of power times excess phosphorus at a constant substrate temperature at low power.

It has been found that at low values of RF power times excess phosphorus supplied that there have been produced polyphosphide films of $KP_{15}$, phophorus and $KP_x$ wherein x ranges from 15 to infinity, which have a layer-like local order as distinct from the parallel tube order of the polyphosphide produced according to the above-identified related application. As indicated in the related application based on USSN 581,115 such layer-like polyphosphides have particular uses as insulating layers and in passivation of III-V semiconductors.

At higher values of power times excess phosphorus supplied, it has been possible to vary the composition of the polyphosphide deposited according to the present process by varying the substrate temperature. At low substrate temperatures, such as room temperature, the polyphosphide films produced have a local order comprising highly disordered tubes. As the substrate temperature is raised, the tubes become more ordered.

Other pnictides, pnictide compounds and polypnictides may be deposited according to the present invention.

Thus, it appears that the total amount of energy supplied to the system comprising the substrate temperature and the RF power governs the local order obtained in the deposited films. Put another way, the energy of the various cracked phosphorus species at the surface of the substrate must be very high for highly ordered microcrystalline structure to be obtained.

The present apparatus and method may be used to supply other pnictides to a sputtering system and may be utilized to grow polycrystalline and crystalline films of compound or intermetallic semiconductors comprising a pnictide. Thus, the epitaxial growth by the present process of layers of varying compound or intermetallic pnictide semiconductors is contemplated.

"III-V semiconductors" as used herein means those semiconductors commonly called intermetallic or compound, formed of compounds of elements from Group III and Group V of the Periodic Table, such as aluminium phosphide, aluminium arsenide, aluminium antimonide, gallium phosphide, gallium arsenide, gallium antimonide, indium phosphide, indium arsenide and indium antimonide and the ternary and quaternary semiconductors. By "pnictide" is meant those elements from Group V of the Periodic Table, namely nitrogen, phosphorus, arsenic, antimony and bismuth.

CLAIMS:

1. A pnictide film deposition apparatus characterised in that it comprises:

    (A) a reservoir (70) for containing heated pnictide;

    (B) means (48) for passing an inert gas therethrough;

    (C) a vacuum film deposition chamber (44); and

    (D) means (76) for supplying the said inert gas carrying the said pnictide as a vapour species after passing through the said pnictide to the said deposition chamber.

2. An apparatus as claimed in claim 1 wherein the said deposition chamber comprises sputtering apparatus (20).

3. An apparatus as claimed in claim 2 wherein the said sputtering apparatus is RF sputtering apparatus.

4. A process for the vacuum deposition of a pnictide film characterised in that it comprises passing an inert gas through heated pnictide and supplying the product gas to a vacuum chamber.

5. A process as claimed in claim 4 wherein the vacuum chamber is maintained at a pressure above $10^{-4}$ Torr $(1.33 \times 10^{-2}$ Pa$)$.

6. A process as claimed in claim 5 wherein the pressure is maintained above $10^{-3}$ Torr $(1.33 \times 10^{-1}$ Pa$)$.

7. A process as claimed in any of claims 4 to 6 comprising sputtering within the vacuum chamber.

8. A process as claimed in claim 7 comprising sputtering in the presence of a Pnictide$_4$ species introduced in the inert carrier gas so as to deposit a pnictide film on a substrate.

9. A process as claimed in any of claims 4 to 8 wherein the pnictide film is a compound or is elemental.

10. A process as claimed in claim 9 wherein the compound is a III-V compound.

11. A process as claimed in claim 10 wherein the compound is InP or GaAs.

12. A process as claimed in any of claims 4 to 11 comprising controlling the local order of the pnictide film by controlling the temperature of the substrate and/or the sputtering power and/or the rate of supply of the pnictide species.

13. A process as claimed in any of claims 4 to 12 wherein the pnictide is phosphorus, arsenic or antimony.

14. A process as claimed in any of claims 4 to 13 wherein the pnictide film is $KP_x$, wherein x is from 15 to infinity.

15. A process as claimed in any of claims 4 to 14 wherein the pnictide film is a polyphosphide.

16. A process as claimed in any of claims 4 to 15 wherein the pnictide is a compound semiconductor.

FIG.1

FIG. 2

## FIG. 3

POTASSIUM DEPOSITION RATE VS. PLASMA POWER

# FIG. 4

POTASSIUM DEPOSITION RATE VS. SUBSTRATE TEMPERATURE

# FIG. 5

**PHOSPHORUS DEPOSITION RATE VS. EXCESS $P_4$ X PLASMA POWER**

$D_P$ ($\overset{\circ}{A}$/MIN)

$T_S$ = 23°C

$T_S$ = 250°C

POWER X EXCESS P ($10^4$ WATTS X GRAMS/MIN)